# EUROPÄISCHE PATENTANMELDUNG

(11) **EP 1 318 549 A2**
(43) Veröffentlichungstag der Anmeldung: **11.06.2003**
(21) Anmeldenummer: 02023299.7
(22) Anmeldetag: 17.10.2002
(51) Int. Cl.: H01L 33/00

(54) **Verfahren zur Herstellung eines optoelektronischen Halbleiter-Bauelementes und damit hergestelltes Bauelement**

(30) Priorität: 05.12.2001 DE 10159544
(71) Anmelder: Patent-Treuhand-Gesellschaft für elektrische Glühlampen mbH, 81543 München (DE)
(72) Erfinder: Braune, Bert, 93173 Wenzenbach (DE); Deisenhofer, Manfred, 86450 Altenmünster (DE); Messner, Ekkehard, Dr., 86163 Augsburg (DE)

(57) **Zusammenfassung**

Ein Herstellverfahren für ein Halbleiterbauelement zeichnet sich durch folgende Verfahrensschritte aus:
a) Herstellen und Bereitstellen eines Gehäuses, das zumindest einen Grundkörper aufweist;
b) Fertigen zweier Bohrungen im Grundkörper, deren Querschnitte den beiden Durchführungen angepasst sind;
c) Befüllen der Bohrungen;
d) Abdichten der Bohrungen.

Das Befüllen der Bohrungen erfolgt insbesondere durch Einsetzen von massiven Durchführungen, die anschließend durch Klebstoff oder Glaslot abgedichtet werden.

## Beschreibung

### Technisches Gebiet

Die Erfindung geht aus von einem Verfahren zur Herstellung eines optoelektronischen Halbleiter-Bauelementes und damit hergestelltes Bauelement gemäß dem Oberbegriff des Anspruchs 1. Es handelt sich dabei insbesondere um Lumineszenzdioden (LED), die im UV oder Blauen Spektralbereich emittieren.

### Stand der Technik

Bisher kommen für LEDs überwiegend Kunststoffgehäuse zum Einsatz, die im Spritzgussverfahren direkt auf den Leiterrahmen (Metall-Leadframe) aufgespritzt werden. Bei diesen Gehäusen kommt es durch die von der LEDemittierten Strahlung zu einer Schädigung (Versprödung etc.) des Kunststoffes, was letztendlich das Gehäuse zerstören, oder wichtige Eigenschaften des Gehäuses, wie die Feuchtigkeitsdichtigkeit, beeinträchtigen kann. Der Schädigungsprozess wird dabei zusätzlich durch die Temperaturbelastung im Brennbetrieb verstärkt. Dies ist besonders relevant bei LEDs, die kurzwellige Strahlung im blauen oder ultravioletten Spektralbereich emittieren.

Aus der EP-A 933 823 ist bereits ein Verfahren zur Herstellung eines optoelektronischen Halbleiter-Bauelementes und damit hergestelltes Bauelement bekannt, bei dem die einzelnen Bauteile des Gehäuses aus Pressglas oder Sinterglas bestehen und sich nur wenig im thermischen Ausdehnungskoeffizienten unterscheiden dürfen (weniger als 15 %). Die Gehäusebauteile werden miteinander verklebt. Alternativ kann der Grundkörper einstückig als Pressglaskörper ausgebildet sein, wobei der Leiterrahmen in den Grundkörper eingebettet wird. Dafür werden von einem Glasrohling (Stab) Einzelstücke abgeschnitten, mit dem Leiterrahmen in Kontakt gebracht, erhitzt und formgepresst. Auf diese Weise wird der Leiterrahmen direkt in das Gehäuse eingebettet. Nachteilig daran ist, dass der Leiterrahmen eine geringe Symmetrie besitzt (er ist flach, weil er aus einem Blech herausgestanzt ist, und besitzt eine verwinkelte Gestalt mit Auswüchsen), so dass eine Abdichtung mittels Formpressen nur schwer gelingt.

### Darstellung der Erfindung

Es ist Aufgabe der vorliegenden Erfindung, ein Verfahren zur Herstellung eines optoelektronisches Bauelements gemäß dem Oberbegriff des Anspruchs 1 bereitzustellen, dessen Gehäuse sowohl Licht- als auch UV-beständig ist und insbesondere auch temperaturbeständig und feuchtigkeitsdicht ist.

Diese Aufgabe wird durch die kennzeichnenden Merkmale des Anspruchs 1 gelöst. Besonders vorteilhafte Ausgestaltungen finden sich in den abhängigen Ansprüchen.

Ein weiterer Aspekt der Erfindung ist ein insbesondere damit hergestelltes Halbleiterbauelement.

Es wird ein Halbleiterbauelement vorgestellt, dessen Gehäuse aus feuchtigkeitsbeständigem Glas, Sinterglas oder Keramik gefertigt ist. Dabei kann fast jedes beliebige Glas verwendet werden, sei es ein Weichglas oder bleifreies übliches Silikatglas. Als Sinterglas kann beispielsweise ein Wismutboratglas, insbesondere Cerdec 101179 eingesetzt werden. Als keramischer Werkstoff eignet sich beispielsweise Al₂O₃. aus einem dieser Materialien ist das Gehäuse entweder vollständig oder zumindest dessen Grundkörper gefertigt. Diese Materialien unterliegen keiner relevanten Alterung oder Schädigung durch sichtbares oder UV-Licht.

Das Gehäuse umfasst funktional zumindest einen Grundkörper. insbesondere ist häufig noch ein Aufsatz angegliedert, der entweder auf dem Grundkörper befestigt ist oder besonders bevorzugt mit ihm eine Einheit bildet. Weiter sind elektrische Anschlüsse erforderlich, die den Chip mit einer elektrischen Spannungsquelle verbinden können. In der Vergangenheit wurde dafür ein üblicher Leiterrahmen oder Leadframe verwendet. Es hat sich jedoch gezeigt, dass er bei diesen Materialien nur schwer im Gehäuse abzudichten ist. Erfindungsgemäß werden statt dessen als elektrische Anschlüsse Durchführungen hoher Symmetrie verwendet, die zylindrisch sind, insbesondere mit kreisförmigem Querschnitt oder zumindest ovalem oder elliptischen Querschnitt. Das Verhältnis der Halbachsen sollte insbesondere zwischen 1:1 und 2:1 liegen.

Dadurch ist es möglich, ein neuartiges, besonders einfaches Verfahren der Herstellung anzuwenden. Es zeichnet sich durch die Schritte
a) Herstellen und Bereitstellen eines Gehäuses mit Grundkörper;
b) Anfertigen zweier Bohrungen (ggf. auch mehr Bohrungen) im Gehäuse, insbesondere im Grundkörper des Gehäuses, deren Querschnitte den beiden Durchführungen angepasst sind;
c) Befüllen der Bohrungen mit den Durchführungen; dies geschieht entweder durch Einsetzen massiver Stifte oder Einfüllen eines leitenden Rohmaterials (beispielsweise ein Pulver oder eine Paste);
d) Abdichten der Bohrungen; dies erfolgt entweder durch Abdichtmittel wie Klebstoff oder Glaslot oder Metalllot oder durch Aushärten (Einsintern oder Erkalten) des Rohmaterials.

Dabei wird der Formkörper zunächst als Ganzes aus Glas, Sinterglas oder Keramik durch Pressen oder Sintern hergestellt und dann werden im zweiten Schritt die Öffnungen für die Durchführungen nachträglich gebohrt. Dies kann durch Laserstrahlen, mechanisches Bohren oder Wasserstrahlschneiden erfolgen. Der Strahlquerschnitt des Lasers (oder Wasserstrahls) kann dabei dem Querschnitt der Durchführung angepasst werden, wenn die Öffnung nicht mechanisch hergestellt wird. Ein typischer Durchmesser der Durchführung ist 0,3 bis 0,4 mm.

Im Falle der Verwendung eines Rohmaterials, bei dem die Durchführung bündig mit den Oberflächen des Grundkörpers abschließt, kann später für bestimmte Anwendungen ein zusätzlicher Verfahrensschritt des Anbringens einer Kontaktschicht aus Weichlot an der Unterseite (Boden) des Grundkörpers vorteilhaft sein, um beispielsweise eine einfache Kontaktierung zu einer Platine zu erreichen.

Der damit herstellbare Formenschatz an LED-Gehäusen reicht von Radial-LEDs bis zu sog. Top-LEDs, wie sie im eingangs erwähnten Stand der Technik beschrieben sind. Bevorzugt wird ein Gehäuse mit integralem Reflektor als Aufsatz auf dem Grundkörper verwendet. Die Durchführungen können aus an sich bekannten Materialien wie Kupfer, Kupfer-Manteldraht oder Metalllegierungen wie Ni-Fe-Legierungen gefertigt sein. Oft sind sie einfache massive Stifte.

Die Herstellung des Gehäuses kann auch auf andere Weise erfolgen.Beispielsweise kann das Pressen und Sintern eines Formkörpers aus Sinterglas so erfolgen, dass Bohrungen bereits mitgeformt werden. Oder der Formkörperwird aus Keramik gesintert, wobei ein Spritzgussverfahren Anwendung findet, bei dem die Bohrungen bereits mitgeformt werden. Bei hoher Symmetrie und relativ kleinem Durchmesser der Durchführungen kann das Gehäuse aus Glas gepresst werden unter gleichzeitigem Einpressen der Durchführungen.

Der Vorteil der Verwendung eines Gehäuses aus Glas, Sinterglas, Glaskeramik oder Keramik ist, dass es keiner Alterung oder Schädigung durch die emittierte Strahlung unterliegt. Geeignet sind helle, insbesondere weiße, aber auch transparente, Materialien mit hoher Reflexion. Bei Gläsern kommen dabei vor allem Pressgläser, die opal (und daher oft weiß erscheinen) sind, oder auch beschichtete klare Gläser in Frage. Durch eine geeignete Färbung (z.B. gelbe reflektierende Oberfläche) oder Beschichtung (metallisch wie Aluminium oder metalloxidisch wie Titanoxid) lässt sich die Intensität und der spektrale Verlauf des reflektierten Lichtes variieren. Besonders bevorzugt ist Sinterglas, das als Glaspulver bei Raumtemperatur kalt verpresst wird (Grünkörper) und dann gesintert wird bis es fest ist. Ein derartiges Glas ist von Natur aus trüb. Ähnlich kann auch Keramik verarbeitet werden.

Insbesondere hat das Gehäuse einen Grundkörper mit Boden, Decke und Seitenwand, durch den zwei Stifte als Zuleitungen vertikal oder auch davon abweichend (schräg oder horizontal) hindurchgeführt sind. im Falle besonderer Kontaktierungswünsche kann mindestens ein Stift aus einer hochgezogenen Seitenwand des Gehäuses herausgeführt werden. Das Gehäuse kann insbesondere einen integralen Aufsatz aufweisen, der insbesondere als Reflektor ausgebildet ist.

Der Grundkörper kann insbesondere noch von einer Manschette wenigstens teilweise ummantelt sein. Diese kann aus billigem, leicht formbaren Material, beispielsweise nicht-strahlungsbeständigem Kunststoff, gefertigt sein. Dabei können die beiden Durchführung im Falle ihrer vertikalen Anordnung in dieser Manschette vorjustiert oder starr befestigt sein, was die Montage erleichtert. Diese Manschette kann leicht einer gewünschten äußeren Form angepasst werden.Sie ist durch den Grundkörper gegen die Strahlung des Halbleiterbauelements geschützt. Insbesondere absorbiert dieser die gefährliche UV-Strahlung, gleichzeitig wirkt er als Wärmedämmung gegen die Manschette.

Der Querschnitt einer ersten Durchführung sollte bevorzugt so angepasst sein dass ein LED-Chip darauf positioniert werden kann. Die Befestigung des Chips kann vor oder nach der Montage der Durchführung erfolgen. Die zweite Durchführung kann dagegen kleiner gewählt werden.

Die Durchführungen können massive Stifte sein, so dass sie außen gut kontaktiert werden können. Bei speziellen Anwendungen (für Platinen o.ä.) sind Durchführungen vorteilhaft, die aus leitendem Rohmaterial als Sinterkörper gebildet sind. Für eine bessere Haftung und leichtere Einbringung des Rohmaterials ist ein wachsender Querschnitt der Bohrung, insbesondere ein konischer, von Vorteil.

Der große Vorteil, verglichen mit einer Direkteinschmelzung der Anschlüsse, einer separaten oder nachträglichen Bereitstellung der Bohrungen ist, dass keine genaue Anpassung der thermischen Ausdehnungskoeffizienten zwischen Gehäuse und Durchführung notwendig ist. Dies gilt vor allem bei Verwendung von Klebstoff als Abdichtmittel, wie beispielsweise organischer Kleber auf Silikonbasis.

### Figuren

Im folgenden soll die Erfindung anhand mehrererAusführungsbeispiele näher erläutert werden. Es zeigen:
- Figur 1: ein Halbleiterbauelement, im Schnitt;
- Figur 2: dasselbe Halbleiterbauelement in Draufsicht;
- Figur 3: ein weiteres Halbleiterbauelement im Schnitt;
- Figur 4: ein weiteres Halbleiterbauelement im Schnitt;
- Figur 5: ein weiteres Halbleiterbauelement im Schnitt.

### Beschreibung der Zeichnungen

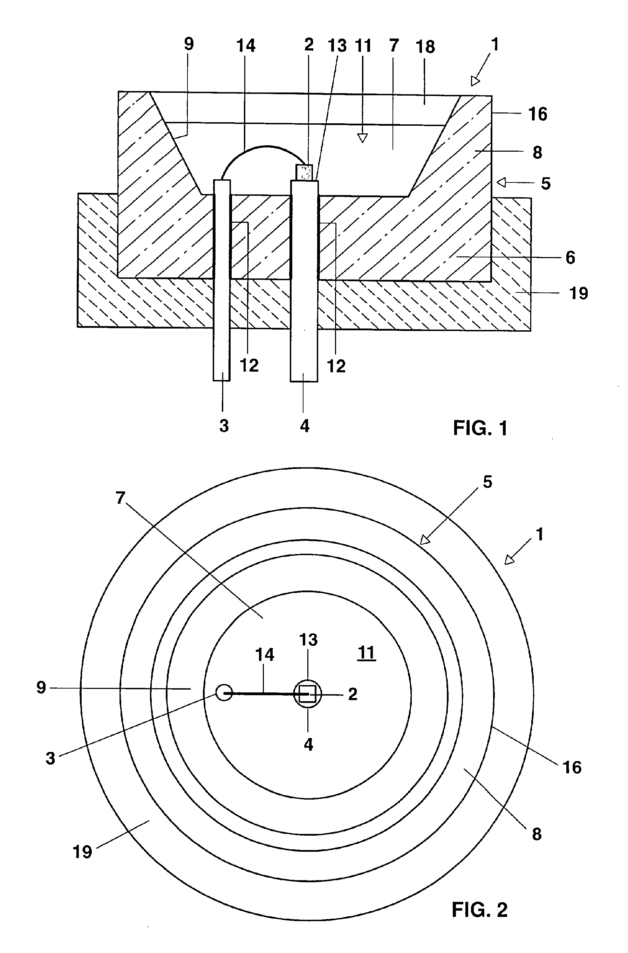

In Figur 1 und 2 ist ein optoelektronisches Halbleiter-Bauelement 1 gezeigt. Kernstück ist der primär UV-Strahlung emittierende Chip 2, der mit elektrischen Anschlüssen 3, 4 verbunden ist, die als Durchführungen in Gestalt einfacher Stifte aus Cu-Manteldraht ausgebildet sind. Einer der Stifte, 3, mit einem Durchmesser von 0,3 mm ist über einen Bonddraht 14 an den Chip angeschlossen. Der Chip 2 sitzt direkt auf der breiten Frontfläche 13 des zweiten Stiftes 4, der einen Durchmesser von 0,4 mm besitzt. Die beiden Stifte sind mittels Klebstoff (Silikon) 12 in ihren zugehörigen rohrförmigen Bohrungen feuchtigkeitsdicht abgedichtet. Alternativ kann auch Glaslot oder Metalllot verwendet werden. Auch direktes Einschmelzen der Elektrodenstifte ist möglich.

Das Gehäuse 5 selbst besteht aus Sinterglas, oder auch Al₂O₃-Keramik. Es ist funktionell in einen runden (oder auch rechteckigen) Grundkörper 6 und einen Aufsatz 8 gegliedert. Der Grundkörper 6 bildet mit dem ringförmigen Aufsatz 8 eine integrale Baueinheit, dessen hochgezogene Seitenwand 16 den Chip umgibt und in seinem Inneren eine Ausnehmung 7 frei lässt. Die innere schräge Wand des Aufsatzes 8 ist als Reflektorkontur 9 geformt. Der Aufsatz kann, falls gewünscht, auch separat aus anderem Material gebildet sein.

Die Ausnehmung 7 innerhalb des Reflektors 9 ist, wie an sich bekannt, mit einem transparenten Gießharz (Silikon) 11, das evtl. einen Wellenlängen konvertierenden Leuchtstoff umfasst, gefüllt.

Die Anordnung des LED-Chips 2 auf dem dicken Stift 4 mit relativ großem Durchmesser erlaubt eine sehr gute Wärmeableitung für die LED. An dem Aufsatz 8 ist noch eine Abdeckscheibe 18 befestigt.

Die Außenseite des Gehäuses im Bereich des Grundkörpers ist von einer Kunststoffmanschette 19 umschlossen, die jede beliebige Gestalt (beispielsweise rund oder eckig) besitzen kann, abhängig von der gewünschten Einbauform. Dieser Kunststoff muss nicht beständig gegen UV-Strahlung sein, da für das Gehäuse, vor allem den Grundkörper, vorteilhaft ein UV-undurchlässiges Glas verwendet wird, das die kurzwellige Strahlung abschirmt.

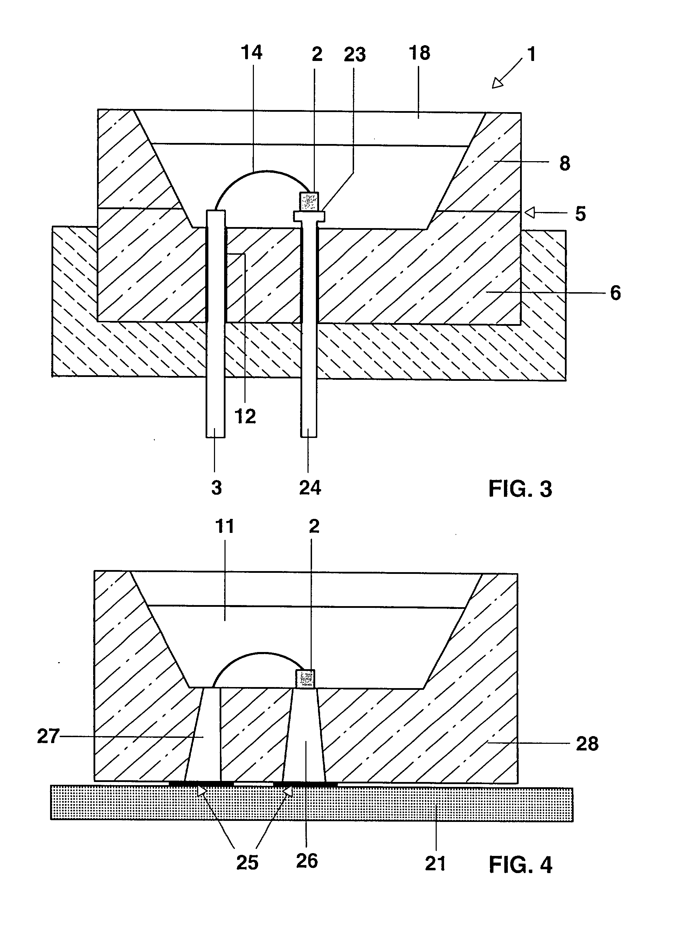

Figur 3 zeigt ein Halbleiterbauelement, das im Prinzip dem in Figur 1 ähnelt (gleiche Bezugsziffern bezeichnen gleiche Teile). Im Unterschied dazu verwendet es jedoch eine Durchführung 24, die als dünner Stift ausgebildet ist. An seinem innen liegenden Ende ist eine tellerförmige Verbreiterung 23 angesetzt, auf der der LED-Chip sitzt. Auf diese Weise kann der Durchmesser des Stiftes unabhängig von der Größe des Chips gewählt werden.

Figur 4 zeigt ein Halbleiterbauelement, das im Prinzip dem in Figur 1 ähnelt (gleiche Bezugsziffern bezeichnen gleiche Teile). Im Unterschied dazu verwendet es jedoch Durchführungen 26, 27, die nicht massiv ausgebildet ist. Vielmehr werden die konischen oder auch rohrförmigen Bohrungen im Grundkörper 28 mit einer Paste oder einem Pulver auf Basis eines Metalllotes oder einer leitenden Metallverbindung bzw. eines leitenden Cermets gefüllt. Beispielsweise eignet sich Leitsilber, Platinlot oder auch ein elektrisch leitendes Cermet mit Grundkomponente Al₂O₃ und Mo-Anteil.

Dabei kann der Verfahrensschritt des Befüllens der Bohrung mit einem Cermet direkt nach dem Ansetzen des Presslings bzw. des Grünkörpers erfolgen, wobei anschließend beide Komponenten gemeinsam fertiggesintert werden.

Das Befüllen kann aber auch nachträglich nach dem Fertigstellen des Gehäuses durchgeführt werden. In einer besonders bevorzugten Ausführungsform, die sich gut für die Bestückung von Platinen 21 (SMD-Technik) eignet, besteht jede Durchführung 26, 27 aus einem in die Bohrung eingefüllten erwärmten Lot wie z.B. einer Silberlegierung, das durch Erkalten erstarrt. Dieses Lot ist zumindest etwas höher schmelzend als das für eine Kontaktierung üblicherweise verwendete Weichlot.

Daher kann es mittels einer dünnen Kontaktschicht 25 am Boden des Grundkörpers, die das Ende der Durchführung abdeckt, und die aus einem leitenden Weichlot besteht mit der Platine durch einen Kontaktierungsschritt verbunden werden.

In dieser Ausführungsform werden also keine massiven Stifte in den Pressling eingefügt und dann verklebt, sondern es wird ein sinterfähiges Material wie beispielsweise cermet direkt mit dem Gehäuse zusammengesintert oder es wird eine geeignete Lotpaste bzw. eine geeignete Metallverbindung nachträglich eingefüllt. Beispielsweise kann eine Leitsilberpaste mittels einer Kanüle in die Bohrung eingefüllt werden.

Achtet man darauf, dass die Schmelztemperatur des verwendeten Metalls bzw. der Metalllegierung oder Hartlots wesentlich höher ist als die übliche Temperatur, bei der Weichlote verarbeitet werden, so benötigt man keinen Kunststoffmantel. Statt dessen kann man die Bauform, nachdem sie mit dem LED-Chip bestückt und mit Silikon ausgegossen wurde, direkt als SMD-Bauform auf die Platine auflöten.

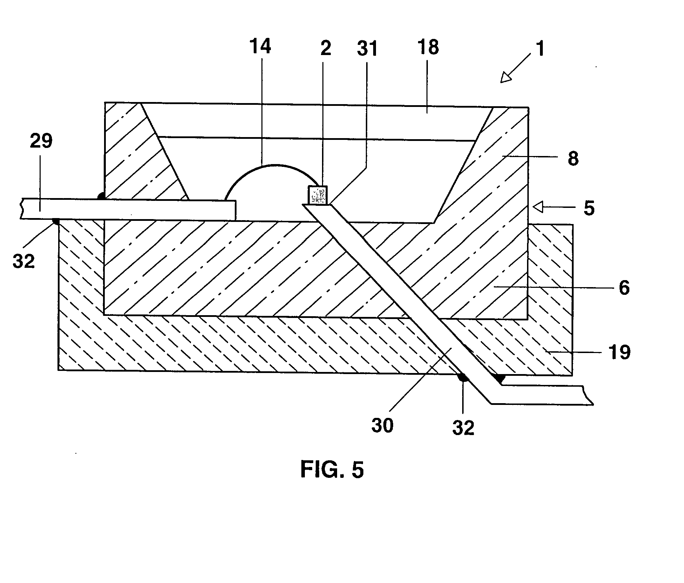

Fig. 5 zeigt eine Ausführungsform, bei der die Durchführungen schräg sitzen (30) bzw. aus der Seitenwand des Gehäuses geführt sind (29). Dadurch können besondere Kontaktierungswünsche erfüllt werden. Die schräge Durchführung 30 ist am inneren Ende 31 so abgeschrägt, dass der Chip 2 darauf sitzen kann. Die horizontal angeordnete zweite Durchführung 29 ist durch eine seitlich austretende Bohrung geführt. Die Abdichtung erfolgt durch Klebstoff.

Der Chip sitzt hier mittelbar oder unmittelbar auf einer der Durchführungen.

## Patentansprüche

1. Verfahren zur Herstellung eines optoelektronischen Halbleiterbauelements (1), wobei das Bauelement einen Chip (2) enthält, der mit elektrischen Stromzuführungen (3,4), die Durchführungen bilden, versehen ist, und wobei der Chip (2) in einem Gehäuse (5) untergebracht ist, das funktional zumindest einen Grundkörper (6) enthält, der aus einem der Materialien Glas, Sinterglas oder Keramik besteht, **dadurch gekennzeichnet, dass** folgende Verfahrensschritte angewendet werden:
a) Herstellen und Bereitstellen eines Gehäuses (5) mit einem Grundkörper (6);
b) Fertigen zweier Bohrungen im Gehäuse, deren Querschnitte den beiden Durchführungen (3,4) angepasst sind;
c) Befüllen der Bohrungen mit den Durchführungen (3,4) oder deren Vorläufern;
d) Abdichten der Bohrungen.

2. Verfahren nach Anspruch 1, **dadurch gekennzeichnet, dass** im Verfahrensschritt c) das Befüllen der Bohrungen durch Einsetzen massiver Stifte (3,4) erfolgt.

3. Verfahren nach Anspruch 2, **dadurch gekennzeichnet, dass** als Verfahrensschritt d) das Abdichten der Bohrungen durch Abdichtmittel (10) angewendet wird

4. Verfahren nach Anspruch 1, **dadurch gekennzeichnet, dass** im Verfahrensschritt c) das Befüllen der Bohrung durch Einfüllen eines leitenden Rohmaterials erfolgt

5. Verfahren nach Anspruch 4, **dadurch gekennzeichnet, dass** als Verfahrensschritt d) das Aushärten des Rohmaterials verwendet wird.

6. Verfahren nach Anspruch 5, **dadurch gekennzeichnet, dass** das Aushärten durch Einsintern oder Erkalten des Rohmaterials erfolgt.

7. Halbleiterbauelement mit einem Gehäuse (5), das einen Grundkörper (6) aufweist, an dem ein LED-Chip (2) mittels zweier Stromzuführungen (3,4), die durch das Gehäuse hindurchgeführt sind, befestigt ist, **dadurch gekennzeichnet, dass** der Grundkörper (6) einstückig aus Glas oder Sinterglas oder Keramik gefertigt ist, wobei im Gehäuse mindestens zwei Bohrungen radialsymmetrischer Geometrie (exakt oder näherungsweise) angebracht sind, durch die die elektrisch leitenden Durchführungen (3,4) hindurchgeführt sind, wobei der LED-Chip (2) auf einer der Durchführungen (4) sitzt.

8. Halbleiterbauelement nach Anspruch 7, **dadurch gekennzeichnet, dass** die Durchführungen massive zylindrische Stifte (3,4) sind

9. Halbleiterbauelement nach Anspruch 7, **dadurch gekennzeichnet, dass** die Durchführungen aus leitendem Rohmaterial gebildete (Verbund-)Körper (26,27) sind.

10. Halbleiterbauelement nach Anspruch 7, **dadurch gekennzeichnet, dass** der Durchmesser der Bohrungen wächst, insbesondere konisch nach innen zunimmt.

11. Halbleiterbauelement nach Anspruch 7, **dadurch gekennzeichnet, dass** zumindest ein Teil des Grundkörpers von einer Manschette (19) ummantelt ist.

12. Halbleiterbauelement nach Anspruch 7, **dadurch gekennzeichnet, dass** das Gehäuse des weiteren einen Aufsatz (8) besitzt, der insbesondere einstückig am Grundkörper angesetzt ist.

13. Halbleiterbauelement nach Anspruch 7, **dadurch gekennzeichnet, dass** die beiden Bohrungen vertikal im Grundkörper angebracht sind.

14. Halbleiterbauelement nach Anspruch 7, **dadurch gekennzeichnet, dass** die beiden Durchführungen (3,4) unterschiedlich gestaltet sind, wobei der Durchmesser der einen Durchführung (4) den Abmessungen des LED-Chips angepasst ist.
